# EUROPÄISCHE PATENTSCHRIFT

(11) **EP 1 126 471 B1**
(45) Veröffentlichungstag und Bekanntmachung des Hinweises auf die Patenterteilung: **22.08.2007**
(21) Anmeldenummer: 01103349.5
(22) Anmeldetag: 13.02.2001
(51) Int. Cl.: G11C 11/22

(54) **Verfahren zum Auslesen oder Speichern eines Zustandes aus einem oder in einen ferroelektrischen Transistor einer Speicherzelle und Speichermatrix**
Method for reading or writing from or into a ferroelectric transistor of a memory cell and a memory matrix
Procédé pour la lecture ou l'écriture d'un transistor ferroélectrique d'une cellule de mémoire d'une matrice de mémoire

(30) Priorität: 14.02.2000 DE 10006444
(43) Veröffentlichungstag der Anmeldung: 22.08.2001
(73) Patentinhaber: Infineon Technologies AG, 81669 München (DE)
(72) Erfinder: Bachhofer, Harald, 81677 München (DE); Braun, Georg, 80339 München (DE); Haneder, Thomas Peter, 81549 München (DE); Hönlein, Wolfgang, Dr., 82008 Unterhaching (DE); Ullmann, Marc, 22085 Hamburg (DE)
(74) Vertreter: Viering, Jentschura & Partner

(56) Entgegenhaltungen:
- EP-A- 0 566 585
- DE-C- 19 840 824
- US-A- 5 946 224

## Beschreibung

Die Erfindung betrifft ein Verfahren zum Auslesen und Speichern des Zustands aus einem oder in einen ferroelektrischen Transistor einer Speicherzelle und eine Speichermatrix.

Ein solches Verfahren und eine solche Speichermatrix sind aus [1] bekannt. Die aus [1] bekannte Speichermatrix ist eine Matrix mit einer Vielzahl von Speicherzellen mit jeweils einem ferroelektrischen Transistor, die in Form einer quadratischen Matrix miteinander verbunden sind. Weiterhin weist die Speichermatrix eine Auslese-/Speicher-Steuervorrichtung auf, mit der ein Zustand eines ferroelektrischen Transistors einer Speicherzelle in der Speichermatrix gespeichert werden kann oder der aktuelle Zustand des entsprechenden ferroelektrischen Transistors der Speicherzelle ausgelesen werden kann.

Gemäß der in [1] beschriebenen Vorgehensweise wird, wenn ein Zustand, in einem ferroelektrischen Transistor einer Speicherzelle der Speichermatrix gespeichert, gelöscht oder gelesen wird, eine entsprechende Auslese-/Speicherspannung an die entsprechenden Wortleitungen bzw. Bitleidungen angelegt. Durch das Anlegen der erforderlichen Auslese-/Speicherspannung werden auch in der Speichermatrix benachbart liegende weitere ferroelektrische Transistoren, die mit dem ferroelektrischen Transistor, dessen Zustand gespeichert oder ausgelesen werden soll, verbunden sind, beeinflusst. Auf diese Weise kann es passieren, dass durch das Auslesen oder Speichern eines Zustands eines ferroelektrischen Transistors der Speichermatrix ein Zustand eines weiteren ferroelektrischen Transistors der Speichermatrix fehlerhaft, das heißt ungewollt verändert wird.

Wie in [1] beschrieben ist, liegt eine Auslese- /Schreibspannung von Vₚₚ/Vᵣᵣ an dem ferroelektrischen Transistor, aus dem bzw. in den ein Zustand ausgelesen bzw. gespeichert werden soll, an. In diesem Fall liegt an den mit diesem ferroelektrischen Transistor verbundenen benachbarten weiteren ferroelektrischen Transistoren eine Störspannung von ungefähr ± Vₚₚ/2 oder ± Vₚₚ/3 an, durch die der Zustand des entsprechenden weiteren ferroelektrischen Transistors fehlerhaft verändert werden kann.

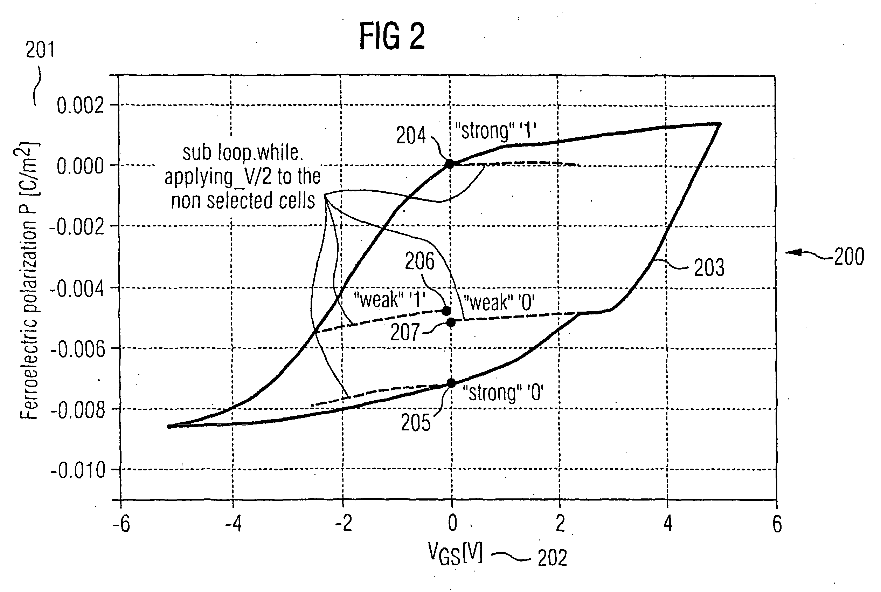

Diese Problematik wird anhand von **Fig.2** im weiteren erläutert.

In **Fig.2** ist ein Diagramm 200 mit einem Verlauf der ferroelektrische Polarisation 201 im Gate eines ferroelektrischen Transistors in Abhängigkeit von einer angelegten Gate-Spannung V_{GS} 202 dargestellt. In dem Diagramm 200 ist die Gate-Spannung 202 in Volt ([V]) und die ferroelektrische Polarisation 201 in Coulomb/m² ([C/m²]) angegeben.

Der Verlauf der ferroelektrischen Polarisation 201 abhängig von der Gate-Spannung 202 wird durch eine Hystereseschleife 203 beschrieben. Wie **Fig.2** zu entnehmen ist, weist ein üblicher ferroelektrische Transistor zwei stabile Polarisationszustände, einen ersten stabilen Polarisationszustand 204 und einen zweiten stabilen Polarisationszustand 205 auf. Durch Ändern der angelegten Gate-Spannung V_{GS}, insbesondere durch eine oben beschriebene "Störspannung" von Vₚₚ/2 oder Vₚₚ/3 kann der Zustand des ferroelektrischen Transistors entlang der Hystereseschleife 203 übergehen in elektrisch nicht-unterscheidbare Polarisationszustände, nämlich in einen ersten nicht-unterscheidbaren Polarisationszustand 206 und in einen zweiten nicht-unterscheidbaren Polarisationszustand 207.

Während es in einfacher Weise möglich ist, den ersten unterscheidbaren Polarisationszustand 204 elektrisch von dem zweiten unterscheidbaren Polarisationszustand 205 zu unterscheiden, womit zwei unterschiedliche Zustände durch den ferroelektrischen Transistor innerhalb der Speichermatrix realisiert und erkannt werden können, ist eine solche elektrische Unterscheidbarkeit bei den nicht-unterscheidbaren Polarisationszuständen 206, 207 nicht gewährleistet.

Somit kann durch eine solche Störspannung der in benachbarten weiteren ferroelektrischen Transistoren in der Speichermatrix gespeicherte Zustand verändert werden oder zumindest undefiniert werden, das heißt es wird ein Polarisationszustand in dem entsprechenden benachbarten ferroelektrischen Transistor gebildet, der nicht verlässlich ausgelesen, das heißt elektrisch unterschieden werden kann.

Ein weiterer ferroelektrischer Transistor und ein Verfahren zu dessen Herstellung sind in [2] beschrieben.

Weiterhin ist es aus [3] bekannt, die Schwellenspannungen von ferroelektrischen Transistoren in der Speichermatrix durch Implantation von Dotierungsatomen in den Kanalbereich dauerhaft zu erhöhen.

Ferner wird in [4] eine Speicherzellenanordnung mit ferroelektrischen Feldeffekttransistoren beschrieben, bei der zum Einschreiben von Information in eine ausgewählte Speicherzelle zwischen deren Gateelektrode und das Substrat ein elektrisches Feld angelegt wird, das die Sättigungsfeldstärke der ferroelektrischen Schicht überschreitet. Um zu verhindern, dass es bei nicht angewählten Speicherzellen der Speicherzellenanordnung ebenfalls zu einer Umpolarisierung kommt, wird das am Sourcegebiet und am Draingebiet der nicht ausgewählten Transistoren anliegende Potential angehoben, so dass dort keine Umpolarisation der ferroelektrischen Schicht auftritt.

In [5] wird ein ferroelektrischer Transistor beschrieben, der zwei Source-/Drain-Gebiete, einen Kanalbereich, eine erste Gate-Elektrode und eine zweite Gateelektrode aufweist, wobei zwischen der ersten Gateelektrode und dem Kanalbereich eine Schicht aus ferroelektrischem Material vorgesehen ist.
Zwischen die erste Gateelektrode und die zweite Gateelektrode ist eine Diodenstruktur geschaltet, die sicherstellt, dass bei einer Ansteuerung der zweiten Gateelektrode zum Auslesen der Speicherzelle die Spannung nur über der zweiten Gateelektrode abfällt. Dadurch wird eine Veränderung der Polarisation der ferroelektrischen Schicht und damit der gespeicherten Information vermieden.

Somit liegt der Erfindung das Problem zugrunde, einen Zustand aus einem ferroelektrischen Transistor auszulesen oder einen Zustand in einen ferroelektrischen Transistor einer Speicherzelle zu speichern, welche Speicherzelle in einer Speichermatrix mit mehreren weiteren Speicherzellen mit weiteren ferroelektrischen Transistoren angeordnet ist, wobei vermieden werden soll, dass die weiteren ferroelektrischen Transistoren in weiteren Speicherzellen der Speichermatrix durch das Auslesen oder Speichern eines ferroelektrischen Transistors in einen nicht-unterscheidbaren Polarisationszustand überführt werden.

Das Problem wird durch das Verfahren zum Auslesen oder Speichern eines Zustands aus einem oder in einen ferrroelektrischen Transistor einer Speicherzelle sowie durch eine Speichermatrix mit den Merkmalen gemäß den unabhängigen Patentansprüchen gelöst.

Bei einem Verfahren zum Auslesen oder Speichern eines Zustands aus einem oder in einen ferroelektrischen Transistor einer Speicherzelle oder zum Speichern eines Zustands in einen ferroelektrischen Transistor der Speicherzelle, die in einer Speichermatrix mit mehreren weiteren Speicherzellen mit weiteren ferroelektrischen Transistoren angeordnet ist, wird der Zustand aus dem ferroelektrischen Transistor ausgelesen oder in den ferrroelektrischen Transistor gespeichert. Während des Auslesens oder Speicherns des Zustands des ferroelektrischen Transistors wird bei mindestens einem weiteren ferroelektrischen Transistor in der Speichermatrix die Schwellenspannung des entsprechenden weiteren ferroelektrischen Transistors insbesondere durch Anlegen einer geeigneten Drain-Substrat-Spannung V_{DS} erhöht.
Dabei wird die Drain-Substrat-Spannung so gewählt, dass jeweils ein Plateau in der Hystereseschleife, die den ferroelektrischen Polarisationsverlauf in dem weiteren ferroelektrischen Transistor beschreibt, gebildet wird so dass ein Übergang in einen nicht-unterscheidbaren Polarisationszustand des weiteren ferroelektrischen Transistors vermieden wird.

Eine Speichermatrix weist mehrere miteinander verbundene Speicherzellen auf, wobei zumindest ein Teil der Speicherzellen mindestens einen ferroelektrischen Transistor aufweist. Weiterhin weist die Speichermatrix eine Auslese-/Speicher-Steuervorrichtung auf, mit der ein Auslesen eines Zustands aus einem ferroelektrischen Transistor einer Speicherzelle der Speichermatrix oder ein Speichern eines Zustands in einen ferroelektrischen Transistor einer Speicherzelle der Speichermatrix gesteuert wird. Die Auslese-/Speicher-Steuervorrichtung ist derart eingerichtet, dass der Zustand aus dem ferroelektrischen Transistor ausgelesen wird oder in den ferroelektrischen Transistor gespeichert wird und währenddessen bei mindestens einem weiteren ferroelektrischen Transistor in der Speichermatrix die Schwellenspannung des weiteren ferroelektrischen Transistors insbesondere durch Anlegen einer geeigneten Drain-Substrat-Spannung V_{DS} erhöht wird. Dabei wird die Drain-Substrat-Spannung so gewählt, dass jeweils ein Plateau in der Hystereseschleife, die den ferroelektrischen Polarisationsverlauf in dem weiteren ferroelektrischen Transistor beschreibt, gebildet wird, so dass ein Übergang in einen nicht-unterscheidbaren Polarisationszustand des weiteren ferroelektrischen Transistors vermieden wird.

Durch das Erhöhen der Schwellenspannung eines weiteren ferroelektrischen Transistors wird der weitere ferroelektrische Transistor in der Weise geschützt, dass er nicht mehr in einen ununterscheidbaren Polarisationszustand übergeht.

Wie erfindungsgemäß erkannt wurde, wird durch Erhöhen der Schwellenspannung insbesondere durch Anlegen einer Drain-Substrat-Spannung V_{DS} eines ferroelektrischen Transistors jeweils ein Plateau in der Hystereseschleife, die den ferroelektrischen Polarisationsverlauf beschreibt, gebildet. Dieses Plateau reicht aus, wie im weiteren beschrieben wird, um einen Übergang in einen nicht-unterscheidbaren Polarisationszustand durch Änderung der Gate-Spannung, die durch Auslesen oder Speichern eines Zustands aus oder in einem benachbarten ferroelektrischen Transistor erzeugt wird, zu vermeiden.

Dies betrifft insbesondere den Bereich des Polarisationsverlaufs, in dem sich der ferroelektrische Transistor aufgrund der anliegenden Gate-Spannung in einem Verarmungszustand der Ladungsträger in dem Kanalbereich des ferroelektrischen Transistors befindet.

Somit wird durch die Erfindung erreicht, dass ein sicheres Auslesen oder Speichern eines Zustands aus oder in einen ferroelektrischen Transistor einer Speichermatrix möglich ist, ohne Zustände weiterer, in der Speichermatrix benachbarter ferroelektrischer Transistoren in einen undefinierten Zustand, das heißt in einen elektrisch nicht-unterscheidbaren Zustand zu überführen, das heißt ohne einen Fehler in den weiteren ferroelektrischen Transistoren zu verursachen.

Bevorzugte Weiterbildungen der Erfindung ergeben sich aus den abhängigen Ansprüchen.

Die im weiteren beschriebenen Ausgestaltungen betreffen sowohl das Verfahren als auch die Ausgestaltung der Auslese-/Speicher-Steuervorrichtung, wobei gemäß der entsprechenden Weiterbildung jeweils die Auslese-/Speicher-Steuervorrichtung derart eingerichtet ist, dass die entsprechende Weiterbildung realisiert ist.

Die entsprechende Ausgestaltung der Auslese-/Speicher-Steuervorrichtung kann mittels eines Computerprogramms, das in einem Speicher der Auslese-/Speicher-Steuervorrichtung vorgesehen ist und mittels eines Prozessors ausgeführt wird, in Software realisiert sein oder mittels einer elektronischen Spezialschaltung in Hardware.

In einer bevorzugten Ausgestaltung der Erfindung ist es vorgesehen, dass der Zustand aus dem ferroelektrischen Transistor ausgelesen oder in den ferroelektrischen Transistor gespeichert wird, indem eine Auslese-/Speicherspannung an die Gate-Elektrode des ferroelektrischen Transistors angelegt wird zum Auslesen oder Speichern des Zustands.

Weiterhin kann das Erhöhen der Schwellenspannung eines weiteren ferroelektrischen Transistors dadurch erfolgen, dass an dem weiteren ferroelektrischen Transistor in der Speichermatrix eine Drain-Substrat-Spannung angelegt wird. Die Drain-Substrat-Spannung V_{DS} kann eine konstante Spannung von ungefähr V_{DS} = ± 3,3 V, je nach Art des ferroelektrischen Transistors, aufweisen (+ 3,3 V bei einem n-Kanal ferroelektrischen Transistor, -3,3 V bei einem p-Kanal ferroelektrischen Transistor).

In einer Speicherzelle der Speichermatrix können mehrere Transistoren, insbesondere mehrere ferroelektrische Transistoren, eingesetzt werden.

Auch wenn im weiteren Ausführungsbeispiel ein ferroelektrischer Transistor eingesetzt wird, der gemäß einem bestimmten Verfahren hergestellt worden ist, so kann jedoch in einer alternativen Ausführungsform ein beliebiger weiterer ferroelektrischer Transistor im Rahmen der Erfindung eingesetzt werden.

So können insbesondere unterschiedliche Materialien für die dielektrische Zwischenschicht, insbesondere einer Dicke zwischen ungefähr 3 nm und 25 nm) des ferroelektrischen Transistors verwendet werden, die beispielsweise Ceoxid CeO₂, Zirkonoxid ZrO₂, Titanoxid TiO₂, Tantaloxid TaO₂ oder Dialuminiumtrioxid AlO₂O₃ aufweisen.

Als ferroelektrische Schicht kann beispielsweise BMF (BaMgF₄), PZT ((PbZr)TiO₃) oder SBT (SrBi₂Ta₂O₉) verwendet werden. Die ferroelektrische Schicht weist eine Dicke zwischen ungefähr 30 nm und 300 nm auf.

Weiterhin kann die Erfindung auch im Rahmen eines p-Kanal ferroelektrischen Transistors eingesetzt werden, auch wenn im weiteren Ausführungsbeispiel die Erfindung anschaulich anhand eines n-Kanal ferroelektrischen Transistors beschrieben wird. In diesem Fall ist lediglich eine Umpolung der entsprechend anzulegenden Spannungen vorzunehmen.

Auch können mehrere elektrische Zwischenschichten innerhalb eines ferroelektrischen Transistors vorgesehen sein, die ein oder mehrere der oben beschriebenen Materialien aufweisen.

Allgemein kann für die elektrische Zwischenschicht des ferroelektrischen Transistors ein beliebiges Perowskit verwendet werden.

Es ist in diesem Zusammenhang anzumerken, dass die Erfindung nicht auf die Struktur des in dem Ausführungsbeispiel beschriebenen ferroelektrischen Transistor beschränkt ist, sondern dass auch beispielsweise die in [1] oder [2] beschriebene Struktur eines ferroelektrischen Transistors im Rahmen der Erfindung ohne weiteres verwendet werden kann.

Ein Ausführungsbeispiel der Erfindung ist in den Figuren dargestellt und wird im weiteren näher erläutert:

Es zeigen:
- Figuren 1a und 1b: eine Speichermatrix mit vier Speicherzellen mit jeweils einem ferroelektrischen Transistor (Figur 1a) und eine Tabelle, in der die entsprechenden an den Leitungen der Speichermatrix anliegenden Spannungen beim Auslesen oder Speichern eines Zustandes in eine Speicherzelle gemäß einem Ausführungsbeispiel der Erfindung dargestellt ist (Figur 1b) ;
- Figur 2: ein Diagramm, in dem der Verlauf der ferroelektrischen Polarisation im Gate eines üblichen ferroelektrischen Transistors in Abhängigkeit der anliegenden Gate-Spannung beim Auslesen oder Speichern eines Zustands aus oder in den ferroelektrischen Transistor gemäß dem Stand der Technik dargestellt ist;
- Figur 3: eine Skizze eines ferroelektrischen Transistors gemäß einem Ausführungsbeispiel der Erfindung;
- Figur 4: ein Ablaufdiagramm, in dem die einzelnen Schritte zum Auslesen bzw. Speichern eines Zustands aus bzw. in einen ferroelektrischen Transistor gemäß einem Ausführungsbeispiel der Erfindung dargestellt ist;
- Figur 5: ein Diagramm, in dem der Verlauf der ferroelektrischen Polarisation im Gate eines üblichen ferroelektrischen Transistors in Abhängigkeit der anliegenden Gate-Spannung beim Auslesen oder Speichern eines Zustands aus oder in den ferroelektrischen Transistor gemäß einem Ausführungsbeispiel der Erfindung dargestellt ist; und
- Figur 6: eine Ausgangskennlinie des ferroelektrischen Transistors gemäß dem Ausführungsbeispiel der Erfindung;

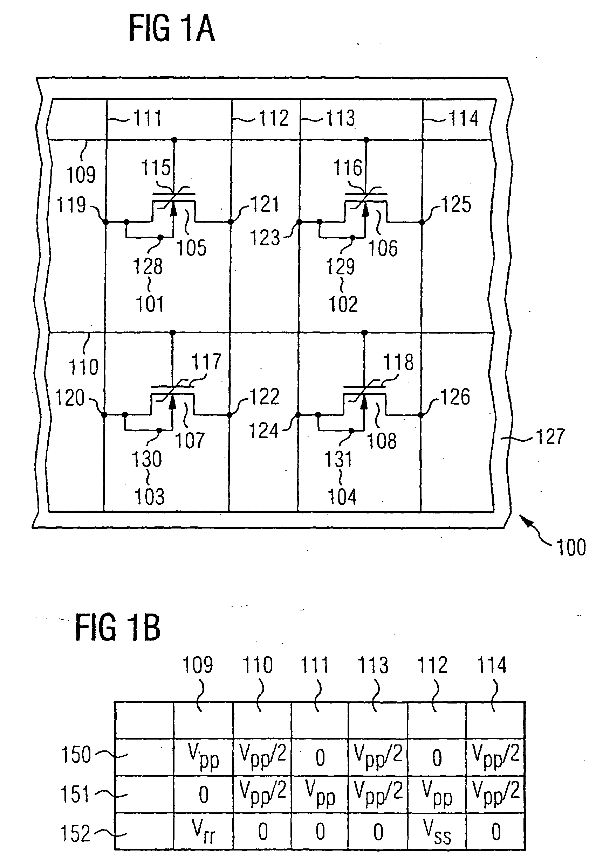

**Fig.1a** zeigt eine Speichermatrix 100 mit vier Speicherzellen 101, 102, 103, 104.

Jede Speicherzelle 101, 102, 103, 104 weist einen ferroelektrischen Transistor 105, 106, 107, 108 auf. Weiterhin weist die Speichermatrix 100 eine erste Wortleitung 109 und eine zweite Wortleitung 110 auf.

Weiterhin weist die Speichermatrix 100 eine erste Bitleitung 111, eine zweite Bitleitung 112, eine dritte Bitleitung 113 und eine vierte Bitleitung 114 auf.

Das Gate 115 des ersten ferroelektrischen Transistors 105 sowie das Gate 116 des zweiten ferroelektrischen Transistors 106 sind mit der ersten Wortleitung 109 gekoppelt.

Das Gate 117 des dritten ferroelektrischen Transistors 107 und das Gate 118 des vierten ferroelektrischen Transistors 108 sind mit der zweiten Wortleitung 110 gekoppelt.

Die Source 119 des ersten ferroelektrischen Transistors 105 und die Source 120 des dritten ferroelektrischen Transistors 107 sind mit der ersten Bitleitung 111 gekoppelt.

Die Drain 121 des ersten ferroelektrischen Transistors 105 und die Drain 122 des dritten ferroelektrischen Transistors 107 sind mit der zweiten Bitleitung 112 verbunden.

Die Source 123 des zweiten ferroelektrischen Transistors 106 und die Source 124 des vierten ferroelektrischen Transistors 108 sind mit der dritten Bitleitung 113 verbunden.

Die Drain 125 des zweiten ferroelektrischen Transistors 106 und die Drain 126 des vierten ferroelektrischen Transistors 108 sind mit der vierten Bitleitung 114 verbunden.

Die Wortleitungen 109, 110 sowie die Bitleitungen 111, 112, 113, 114 sind mit einer Auslese-/Speicher-Steuervorrichtung 127 verbunden.

Das Speichern eines Zustandes eines ferroelektrischen Transistors in der Speichermatrix 100 sowie das Auslesen eines Zustandes eines ferroelektrischen Transistors in der Speichermatrix 100 wird von der Auslese-/Speicher-Steuervorrichtung 127 durch Anlegen verschiedener Spannungen an die entsprechenden Wortleitungen 109, 110 und/oder an die entsprechenden Bitleitungen 111, 112, 113, 114 gesteuert, wie im weiteren näher erläutert wird.

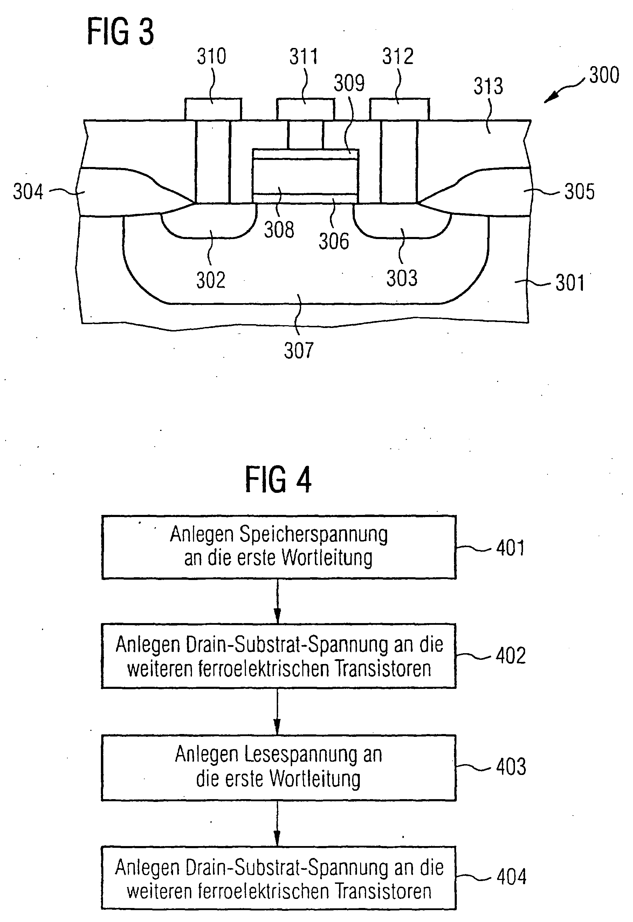

**Fig.3** zeigt einen ferroelektrischen Transistor 300, wie er als erster ferroelektrischer Transistor 105, als zweiter ferroelektrischer Transistor 106, als dritter ferroelektrischer Transistor 107 und als vierter ferroelektrischer Transistor 108 in der Speichermatrix 100 vorgesehen ist.

Der ferroelektrische Transistor 300 weist ein p-dotiertes Substrat 301 aus Silizium auf, sowie einen Source-Bereich 302 und einen Drain-Bereich 303, denen angrenzend zwei Siliziumoxid-Bereiche 304, 305 angeordnet sind. Diese Bereiche werden mit einem üblichen CVD-Verfahren abgeschieden. Anschließend wird eine dielektrische Zwischenschicht 306 über dem Kanalbereich 307 zwischen dem Source-Bereich 302 und dem Drain-Bereich 303 des ferroelektrischen Transistors 300 aus Siliziumoxid abgeschieden. Die dielektrische Zwischenschicht 306 kann alternativ auch ein anderes Dielektrikum aufweisen, beispielsweise Al₂O₃, CeO₂ oder ZrO₂, das beispielsweise mit Hilfe eines CVD-Verfahrens aufgebracht wird.

Dann wird darauf beispielsweise mit Hilfe eines CVD-Verfahrens eine ferroelektrische Schicht 308 aufgebracht, die SBT (SrBi₂Ta₂O₉) oder PZT ((Pb,Zr)TiO₃) enthalten kann.

Die Temperung dieser beiden Schichten 306, 308 zur Einstellung der gewünschten Schichteigenschaften kann der Reihe nach, also nach der Abscheidung jeder einzelnen Schicht erfolgen, sie kann aber auch - falls dies gewünscht ist - in einem Schritt nach der Abscheidung beider Schichten 306, 308 erfolgen.

Die dielektrische Zwischenschicht 306 und die ferroelektrische Schicht 308 werden anschließend durch einen Ätzprozess strukturiert.

Wird eine metallische Gate-Elektrode 309 verwendet, so wird diese durch ein Sputter-Verfahren erzeugt und anschließend durch einen Ätzprozess strukturiert.

Die metallische Elektrode kann als Hartmaske zur Strukturierung der darunter liegenden Schichten verwendet werden.

Die Implantation des Source-Bereichs 302 und des Drain-Bereichs 303 kann selbstjustiert zum Gate-Stack erfolgen.

Die restlichen Prozessschritte vor und nach der Herstellung des ferroelektrischen Gate-Stacks können analog zu Standard-CMOS-Fertigungsverfahren erfolgen.

Ferner weist der ferroelektrische Transistor 300 Kontakte 310, 311, 312 auf, die entsprechend mit der Source 302, der Drain 303 und der Gate-Elektrode 309 leitend verbunden sind.

Weiterhin weist der ferroelektrische Transistor 300 eine Silizium-Planarisierungsschicht 313 auf.

Im weiteren wird anhand von **Fig.4** und **Fig.1b** das Auslesen und Speichern eines Zustands in den ersten ferroelektrischen Transistor 105 näher erläutert.

In einem ersten Schritt (Schritt 401) wird zum Speichern eines ersten Zustands eine Speicherspannung Vₚₚ, die gemäß dem Ausführungsbeispiel Vpp = 5V beträgt, an die erste Wortleitung 109 angelegt.

Über dem Gate der jeweiligen weiteren ferroelektrischen Transistoren wird eine Spannung Vₚₚ/2 oder Vₚₚ/3 an die nicht selektierte zweite Wortleitung 110 sowie an der nicht selektierten dritten Bitleitung 113 und der nicht selektierten vierten Bitleitung 114 angelegt.

An die erste Bitleitung 111 und die zweite Bitleitung 112 wird eine Spannung von 0V angelegt.

Gleichzeitig mit dem Anlegen der Speicherspannung Vₚₚ wird eine Drain-Substrat-Spannung V_{DS} von V_{DS} = + 3,3 V an die weiteren ferroelektrischen Transistoren 106, 107, 108 angelegt, um diese vor einer fehlerhaften Zustandsänderung zu schützen (Schritt 402). In einer alternativen Ausführungsform kann die Drain-Substrat-Spannung V_{DS} = + 3,3 V dauerhaft an alle ferroelektrischen Transistoren der Speichermatrix 100 angelegt werden. Das Anlegen der Drain-Substrat-Spannung V_{DS} = + 3,3 V ist in **Fig.1a** mittels Spannungsquellen 128, 129, 130, 131 in dem Substrat des jeweiligen ferroelektrischen Transistors 105, 106, 107, 108, dargestellt.

In einem weiteren Schritt (Schritt 403) wird der Zustand des ersten ferroelektrischen Transistors 105 ausgelesen, indem an die erste Wortleitung 109 eine Auslesespannung Vᵣᵣ von Vᵣᵣ = 2,6 V angelegt wird und an die zweite Bitleitung 112 eine Spannung Vₛₛ von Vₛₛ = 0,1 V angelegt wird.

Wird die Auslesespannung größer gewählt, so kann zum Schutz der weiteren ferroelektrischen Transistoren 106, 107, 108 wiederum in einem weiteren Schritt (Schritt 404) gleichzeitig mit dem Auslesevorgang die Drain-Substrat-Spannung V_{DS} der weiteren ferroelektrischen Transistoren 106, 107, 108 auf den Wert von V_{DS} = + 3,3 V angelegt werden. Wie oben dargelegt, kann in einer alternativen Ausführungsform die Drain-Substrat-Spannung V_{DS} = + 3,3 V dauerhaft an alle ferroelektrischen Transistoren der Speichermatrix 100 angelegt werden.

Das Löschen des ersten Zustandes in dem ersten ferroelektrischen Transistor 105, das auch als Speichern eines zweiten Zustandes in dem ersten ferroelektrischen Transistor 105 angesehen werden kann, erfolgt durch Anlegen der Speicherspannung Vpp an die erste Bitleitung 111 und die zweite Bitleitung 112.

In diesem Fall wird an die erste Wortleitung 109 eine Spannung von 0 V angelegt. Wiederum wird zum Schutz der weiteren ferroelektrischen Transistoren 106, 107, 108 eine vorzugsweise konstante Drain-Substrat-Spannung V_{bs} von V_{DS} = + 3,3 V angelegt.

Die verschiedenen anliegenden Spannungen zum Speichern 150 des ersten Zustands in den ersten ferroelektrischen Transistor 105, zum Speichern 151 des zweiten Zustands in den ersten ferroelektrischen Transistor 105 und zum Auslesen 152 des Zustandes aus dem ersten ferroelektrischen Transistor 105 sind tabellarisch in Fig.lb dargestellt.

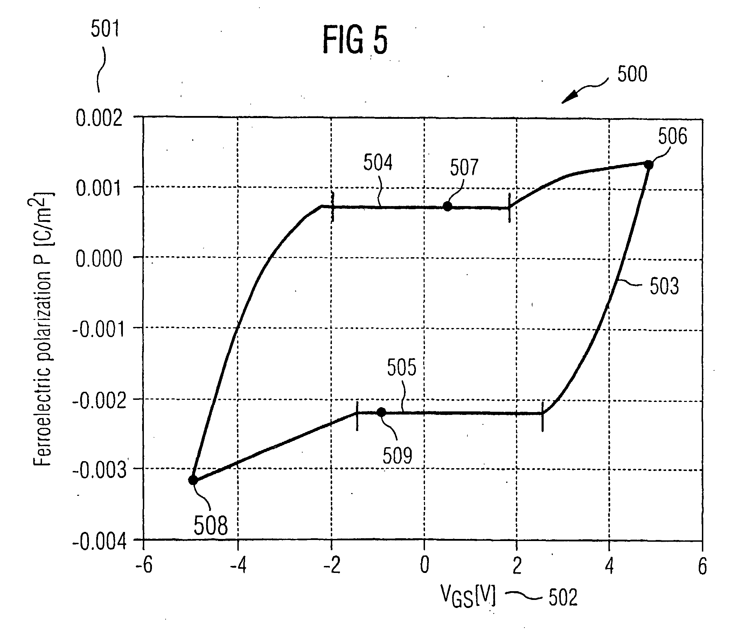

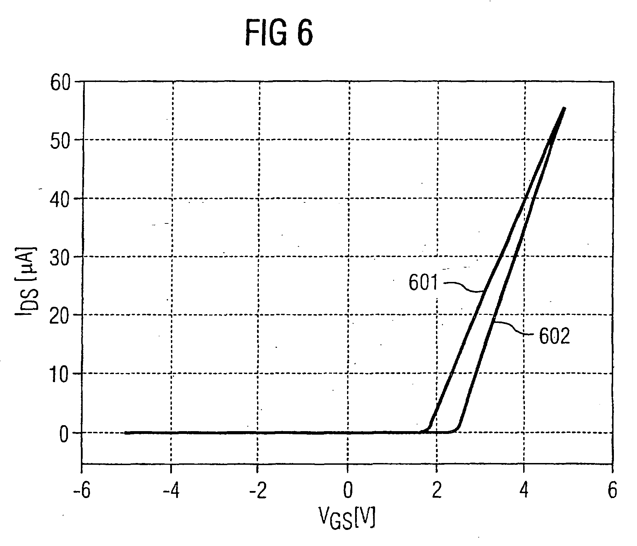

Anhand der **Fig.5** und **Fig.6** wird die erreichte Erhöhung Schwellenspannung des ferroelektrischen Transistors durch Anlegen der entsprechenden Drain-Substrat-Spannung erläutert.

**Fig.5** zeigt den Verlauf 500 der ferroelektrischen Polarisation 501 im Gate eines ferroelektrischen Transistors in Abhängigkeit der Gate-Spannung 502 bei erhöhter Schwellenspannung des ferroelektrischen Transistors, gemäß diesem Ausführungsbeispiel erreicht durch temporäres Anlegen oder dauerhaftes Anlegen einer Drain-Substrat-Spannung in dem jeweiligen weiteren ferroelektrischen Transistor 106, 107, 108 oder an alle ferroelektrischen Transistoren der Speichermatrix 100.

In einer sich ergebenden Hystereseschleife 503 ergeben sich zwei Plateaubereiche 504, 505. Wird nun aufgrund einer Störspannung die Gate-Spannung V_{GS} an einem weiteren ferroelektrischen Transistor 106, 107, 108, welcher sich in einem ersten Zustand, angedeutet durch einen ersten unterscheidbaren Polarisationszustand 506 in der Hystereseschleife 503, befindet, so wird durch Anlegen der Störspannung die Hystereseschleife 503 üblicherweise bei ausreichend großer Drain-Substrat-Spannung lediglich ein Polarisationszustand in dem ersten Plateaubereich 504 eingenommen, symbolisiert durch einen zweiten unterscheidbaren Polarisationszustand 507.

Befindet sich der jeweilige ferroelektrische Transistor in einem zweiten Zustand, wie in der Hystereseschleife 503 durch einen dritten unterscheidbaren Polarisationszustand 508 angedeutet ist, und es wird eine Störspannung angelegt, so wird wiederum für den Fall, dass eine ausreichend große Drain-Substrat-Spannung anliegt und somit der zweite Plateaubereich 505 ausreichend groß ist, lediglich ein Zustand angenommen, der sich in dem zweiten Plateaubereich 505 befindet, symbolisiert durch einen vierten unterscheidbaren Polarisationszustand 509.

Wie **Fig.6** zu entnehmen ist, können der zweite unterscheidbare Polarisationszustand 507 und der vierte unterscheidbare Polarisationszustand 509 voneinander unterschieden werden aufgrund der unterschiedlichen Ausgangskennlinien 601, 602 des Drain-Source-Stroms I_{DS} abhängig von der Gate-Spannung V_{GS}, da sich für den zweiten unterscheidbaren Polarisationszustand 507 die erste Ausgangskennlinie 601 und für den vierten unterscheidbaren Polarisationszustand 509 die zweite Ausgangskennlinie 602 ergibt.

Somit sind selbst der durch eine Störspannung eingenommene zweite unterscheidbare Polarisationszustand 507 von einem eventuell durch einen eine Störspannung eingenommenen vierten unterscheidbaren Polarisationszustand 509 noch elektrisch unterscheidbar.

Anschaulich ist die Erfindung darin zu sehen, dass durch Anlegen einer Drain-Substrat-Spannung die Hystereseschleife des entsprechenden ferroelektrischen Transistors derart verändert wird, dass sich Plateaubereiche in der Hystereseschleife ausbilden, wodurch das Entstehen nicht definierter Polarisationszustände, die elektrisch nicht voneinander unterscheidbar sind, verhindert wird.

Im weiteren werden einige Alternativen zu dem oben dargestellten Ausführungsbeispiel näher erläutert.

Die Erfindung ist nicht auf in die oben beschriebene konkrete Form einer Speichermatrix, insbesondere nicht auf eine vier Speicherzellen aufweisende Speichermatrix beschränkt. Die Erfindung kann im Rahmen einer beliebig ausgestalteten Speichermatrix mit einer beliebigen Anzahl von Speicherzellen, das heißt von ferroelektrischen Transistoren als Speicherzellen, verwendet werden.

Weiterhin kann eine Speicherzelle auch mehrere Transistoren, insbesondere mehrere ferroelektrische Transistoren aufweisen.

In diesem Dokument sind folgende Veröffentlichungen zitiert:
[1] T. Nakamura et al, A Single-Transistor Ferroelectric Memory Cell, IEEE International Solid-State Circuits Conference, ISSCC95, Session 4, Technology Directions: Displays, Photonics and Ferroelectric Memories, S. 68 - 69, 1995
[2] Jong-Son Lyu et al, Metal-Ferroelectric-Semiconductor Field-Effect Transistor (MFSFET) for Single Transistor Memory by Using Poly-Si Source/Drain and BaMgF4 Dielectric, IEDM 1996, S. 503 - 506, 1996
[3] US 5,946,224
[4] EP-A-0-566 585
[5] DE 198 40 824 C

### Bezugszeichenliste

- 100: Speichermatrix
- 101: Speicherzelle
- 102: Speicherzelle
- 103: Speicherzelle
- 104: Speicherzelle
- 105: Erster ferroelektrischer Transistor
- 106: Zweiter ferroelektrischer Transistor
- 107: Dritter ferroelektrischer Transistor
- 108: Vierter ferroelektrischer Transistor
- 109: Erste Wortleitung
- 110: Zweite Wortleitung
- 111: Erste Bitleitung
- 112: Zweite Bitleitung
- 113: Dritte Bitleitung
- 114: Vierte Bitleitung
- 115: Gate erster ferroelektrischer Transistor
- 116: Gate zweiter ferroelektrischer Transistor
- 117: Gate dritter ferroelektrischer Transistor
- 118: Gate vierter ferroelektrischer Transistor
- 119: Source erster ferroelektrischer Transistor
- 120: Source dritter ferroelektrischer Transistor
- 121: Drain erster ferroelektrischer Transistor
- 122: Drain dritter ferroelektrischer Transistor
- 123: Source zweiter ferroelektrischer Transistor
- 124: Source vierter ferroelektrischer Transistor
- 125: Drain zweiter ferroelektrischer Transistor
- 126: Drain vierter ferroelektrischer Transistor
- 127: Auslese-/Speicher-Steuervorrichtung
- 128: Spannungsquelle erster ferroelektrischer Transistor
- 129: Spannungsquelle zweiter ferroelektrischer Transistor
- 130: Spannungsquelle dritter ferroelektrischer Transistor
- 131: Spannungsquelle vierter ferroelektrischer Transistor
- 150: Spannungen zum Speichern des ersten Zustands in den ersten ferroelektrischen Transistor
- 151: Spannungen zum Speichern des zweiten Zustands in den ersten ferroelektrischen Transistor
- 152: Auslesen des Zustandes aus dem ersten ferroelektrischen Transistor

- 200: Verlauf ferroelektrische Polarisation im Gate eines ferroelektrischen Transistors in Abhängigkeit der Gate-Spannung
- 201: Ferroelektrische Polarisation im Gate eines ferroelektrischen Transistors
- 202: Gate-Spannung
- 203: Hysterese-Schleife
- 204: Erster unterscheidbarer Polarisationszustand
- 205: Zweiter unterscheidbarer Polarisationszustand
- 206: Erster nicht-unterscheidbarer Polarisationszustand
- 207: Zweiter nicht-unterscheidbarer Polarisationszustand

- 300: Ferroelektrischer Transistor
- 301: Substrat
- 302: Source-Bereich
- 303: Drain-Bereich
- 304: Siliziumoxid-Bereich
- 305: Siliziumoxid-Bereich
- 306: Polysilizium-Bereich
- 307: Polysilizium-Bereich
- 308: Siliziumoxid-Schicht
- 309: Metallschicht
- 310: dielektrische Zwischenschicht
- 311: Kanalbereich
- 312: Gatebereich
- 313: Schutzschicht

- 401: Anlegen Speicherspannung an die erste Wortleitung
- 402: Gleichzeitig mit dem Anlegen der Speicherspannung Anlegen Drain-Substrat-Spannung an die weiteren ferroelektrischen Transistoren
- 403: Anlegen Lesespannung an die erste Wortleitung
- 404: Gleichzeitig mit dem Anlegen der Lesespannung Anlegen Drain-Substrat-Spannung an die weiteren ferroelektrischen Transistoren

- 500: Verlauf ferroelektrische Polarisation im Gate eines ferroelektrischen Transistors in Abhängigkeit der Gate-Spannung
- 501: Ferroelektrische Polarisation im Gate eines ferroelektrischen Transistors
- 502: Gate-Spannung
- 503: Hysterese-Schleife
- 504: Plateaubereich
- 505: Plateaubereich
- 506: Erster unterscheidbarer Polarisationszustand
- 507: Zweiter unterscheidbarer Polarisationszustand
- 508: Dritter unterscheidbarer Polarisationszustand
- 509: Vierter unterscheidbarer Polarisationszustand

- 601: Erste Ausgangskennlinie
- 602: Zweite Ausgangskennlinie

## Patentansprüche

1. Verfahren zum Auslesen oder Speichern eines Zustands aus einem oder in einen ferroelektrischen Transistor einer Speicherzelle, die in einer Speichermatrix mit mehreren weiteren Speicherzellen mit weiteren ferroelektrischen Transistoren angeordnet ist,
• bei dem der Zustand aus dem ferroelektrischen Transistor ausgelesen wird oder in den ferrroelektrischen Transistor gespeichert wird, und
• bei dem bei mindestens einem weiteren ferroelektrischen Transistor in der Speichermatrix die Schwellenspannung des weiteren ferroelektrischen Transistors erhöht wird, indem an den weiteren ferroelektrischen Transistor in der Speichermatrix eine Drain-Substrat-Spannung angelegt wird, **gekennzeichnet dadurch, daß** die Drain-Substrat-Spannung so gewählt wird, dass jeweils ein Plateau in der Hystereseschleife, die den ferroelektrischen Polarisationsverlauf in dem weiteren ferroelektrischen Transistor beschreibt, gebildet wird, so dass ein Übergang in einen nicht-unterscheidbaren Polarisationszustand des weiteren ferroelektrischen Transistors vermieden wird.

2. Verfahren nach Anspruch 1,
bei dem der Zustand aus dem ferroelektrischen Transistor ausgelesen oder in den ferroelektrischen Transistor gespeichert wird, indem eine Auslese-/Speicherspannung an die Gateelektrode des ferroelektrischen Transistors angelegt wird zum Auslesen oder Speichern des Zustands.

3. Verfahren nach Anspruch 1 oder 2,
bei dem in mindestens einer Speicherzelle der Speichermatrix mehrere Transistoren verwendet werden.

4. Verfahren nach einem der Ansprüche 1 bis 3,
bei dem als Drain-Substrat-Spannung eine Spannung von ungefähr ± 3,3 Volt angelegt wird.

5. Speichermatrix mit
• mehreren miteinander verbundenen Speicherzellen, wobei zumindest ein Teil der Speicherzellen mindestens einen ferroelektrischen Transistor aufweist,
• einer Auslese-/Speicher-Steuervorrichtung, mit der ein Auslesen oder ein Speichern eines Zustands aus einem oder in einen ferroelektrischen Transistor einer Speicherzelle der Speichermatrix gesteuert wird,
• wobei die Auslese-/Speicher-Steuervorrichtung derart eingerichtet ist, dass der Zustand aus dem ferroelektrischen Transistor ausgelesen wird oder in dem ferroelektrischen Transistor gespeichert wird, und
• dass bei mindestens einem weiteren ferroelektrischen Transistor in der Speichermatrix die Schwellenspannung des weiteren ferroelektrischen Transistors erhöht wird, indem an den weiteren ferroelektrischen Transistor in der Speichermatrix eine Drain-Substrat-Spannung angelegt wird, **gekennzeichnet dadurch, daß** die Drain-Substrat-Spannung so gewählt wird, dass jeweils ein Plateau in der Hystereseschleife, die den ferroelektrischen Polarisationsverlauf in dem weiteren ferroelektrischen Transistor beschreibt, gebildet wird, so dass ein Übergang in einen nicht-unterscheidbaren Polarisationszustand des weiteren ferroelektrischen Transistors vermieden wird.

6. Speichermatrix nach Anspruch 5,
bei der die Auslese-/Speicher-Steuervorrichtung derart eingerichtet ist, dass eine Auslese-/Speicherspannung an die Gateelektrode des ferroelektrischen Transistors angelegt wird zum Auslesen oder Speichern des Zustands.

7. Speichermatrix nach Anspruch 5 oder 6,
bei der die Auslese-/Speicher-Steuervorrichtung derart eingerichtet ist, dass zum Erhöhen der Schwellenspannung des weiteren ferroelektrischen Transistors an den weiteren ferroelektrischen Transistor in der Speichermatrix eine Drain-Substrat-Spannung angelegt wird.

8. Speichermatrix nach einem der Ansprüche 5 bis 7,
bei der mindestens eine Speicherzelle der Speichermatrix mehrere Transistoren aufweist.

9. Speichermatrix nach einem der Ansprüche 5 bis 8, bei der die Auslese-/Speicher-Steuervorrichtung derart eingerichtet ist, dass als Drain-Substrat-Spannung eine Spannung von ungefähr ± 3,3 Volt angelegt wird.

## Claims

1. A method for reading or storing a state from or in a ferroelectric transistor of a memory cell which is arranged in a memory matrix having a plurality of further memory cells with further ferroelectric transistors,
• wherein the state is read from the ferroelectric transistor or is stored in the ferroelectric transistor, and
• wherein on at least one further ferroelectric transistor in the memory matrix the threshold voltage of the at least one further ferroelectric transistor is increased by applying a drain-substrate voltage to the further ferroelectric transistor in the memory matrix, **characterized in that** the drain-substrate voltage is chosen in such a manner that a plateau is respectively formed in the hysteresis loop which describes the ferroelectric polarization profile in the further ferroelectric transistor thus preventing a change to an indistinguishable polarization state of the further ferroelectric transistor.

2. The method as claimed in claim 1,
wherein the state is read from the ferroelectric transistor or is stored in the ferroelectric transistor by a read/store voltage being applied to the gate electrode of the ferroelectric transistor in order to read or store the state.

3. The method as claimed in claim 1 or 2,
wherein a plurality of transistors are used in at least one memory cell in the memory matrix.

4. The method as claimed in one of the claims 1 to 3,
wherein a voltage of approximately ± 3.3 volts is applied as the drain-substrate voltage.

5. A memory matrix, comprising
• a plurality of memory cells which are connected to one another, with at least some of the memory cells having at least one ferroelectric transistor,
• a read/store control device, which controls the process of reading or storing a state from or in a ferroelectric transistor of a memory cell in the memory matrix,
• with the read/store control apparatus being set up such that the state is read from the ferroelectric transistor or is stored in the ferroelectric transistor, and
• wherein on at least one further ferroelectric transistor in the memory matrix the threshold voltage of the further ferroelectric transistor is increased by applying a drain-substrate voltage to the further ferroelectric transistor in the memory matrix, **characterized in that** the drain-substrate voltage is chosen in such a manner that a plateau is respectively formed in the hysteresis loop which describes the ferroelectric polarization profile in the further ferroelectric transistor thus preventing a change to an indistinguishable polarization state of the further ferroelectric transistor.

6. The memory matrix as claimed in claim 5,
wherein the read/store control device is set up such that a read/store voltage is applied to the gate electrode of the ferroelectric transistor in order to read or store the state.

7. The memory matrix as claimed in claim 5 or 6,
wherein the read/store control device is set up such that a drain-substrate voltage is applied to the further ferroelectric transistor in the memory matrix for increasing the threshold voltage of the further ferroelectric transistor.

8. The memory matrix as claimed in one of claims 5 to 7,
wherein at least one memory cell in the memory matrix has a plurality of transistors.

9. The memory matrix as claimed in one of the claims 5 to 8,
wherein the read/store control device is set up such that a voltage of approximately ± 3.3 volts is applied as the drain-substrate voltage.

## Revendications

1. Procédé de lecture ou de mémorisation d'un état dans un transistor ferroélectrique d'une cellule de mémoire qui est disposée dans une matrice de mémoire ayant plusieurs autres cellules de mémoire ayant d'autres transistors ferroélectriques,
• dans lequel on lit l'état dans le transistor ferroélectrique ou on mémorise l'état dans le transistor ferroélectrique ; et
• dans lequel on augmente, dans au moins un autre transistor ferroélectrique de la matrice de mémoire, la tension de seuil de l'autre transistor ferroélectrique en appliquant à l'autre transistor ferroélectrique de la matrice de mémoire une tension drain-substrat, **caractérisé en ce que** l'on choisit la tension drain-substrat de façon à former respectivement un plateau dans la boucle d'hystérésis, qui décrit la courbe de polarisation ferroélectrique de l'autre transistor ferroélectrique, de manière à empêcher un passage à un état de polarisation, que l'on ne peut pas distinguer, de l'autre transistor ferroélectrique.

2. Procédé suivant la revendication 1,
dans lequel on lit l'état dans le transistor ferroélectrique ou on mémorise l'état dans le transistor ferroélectrique, en appliquant une tension de lecture/mémorisation à l'électrode de grille du transistor ferroélectrique pour lire ou mémoriser l'état.

3. Procédé suivant la revendication 1 ou 2,
dans lequel on utilise plusieurs transistors dans au moins une cellule de mémoire de la matrice de mémoire.

4. Procédé suivant l'une quelconque des revendications 1 à 3, dans lequel on applique une tension d'environ ± 3,3 volts comme tension de drain-substrat.

5. Matrice de mémoire comprenant :
• plusieurs cellules de mémoire reliées entre elles, au moins une partie des cellules de mémoire ayant au moins un transistor ferroélectrique,
• un dispositif de commande de lecture/mémorisation, par lequel on commande une lecture ou une mémorisation d'un état dans un transistor ferroélectrique d'une cellule de mémoire de la matrice de mémoire,
• le dispositif de commande de lecture/mémorisation étant tel que l'état est lu dans le transistor ferroélectrique où est mémorisé dans le transistor ferroélectrique, et
• en ce que, pour au moins un autre transistor ferroélectrique de la matrice de mémoire, la tension de seuil de l'autre transistor ferroélectrique est élevée en appliquant une tension de drain-substrat à l'autre transistor ferroélectrique de la matrice de mémoire, **caractérisée en ce que** la tension de drain-substrat est choisie de façon à former un plateau à partir de la boucle d'hystérésis, qui décrit la courbe de polarisation ferroélectrique de l'autre transistor ferroélectrique, de manière à empêcher un passage à un état de polarisation, que l'on ne peut pas distinguer, de l'autre transistor ferroélectrique.

6. Matrice de mémoire suivant la revendication 5,
dans laquelle le dispositif de commande de lecture/mémorisation est tel qu'une tension de lecture/mémorisation est appliquée à l'électrode de grille du transistor ferroélectrique pour lire ou mémoriser l'état.

7. Matrice de mémoire suivant la revendication 5 ou 6,
dans laquelle le dispositif de commande de lecture/mémorisation est tel que, pour élever la tension de seuil de l'autre transistor ferroélectrique, il est appliqué une tension de drain-substrat à l'autre transistor ferroélectrique de la matrice de mémoire.

8. Matrice de mémoire suivant l'une quelconque des revendications 5 à 7, dans laquelle au moins une cellule de mémoire de la matrice de mémoire a plusieurs transistors.

9. Matrice de mémoire suivant l'une quelconque des revendications 5 à 8, dans laquelle le dispositif de commande de lecture/mémoire est tel qu'il est appliqué comme tension de drain-substrat une tension d'environ ± 3,3 volt.
